# EUROPEAN PATENT SPECIFICATION

(11) **EP 2 368 929 B1**
(45) Date of publication and mention of the grant of the patent: **31.10.2018**
(21) Application number: 09833468.3
(22) Date of filing: 17.12.2009
(51) Int. Cl.: C08G 59/30, C08J 5/24, C08K 3/00, C08K 5/5435, C08K 5/5465, C08L 63/00, C08G 59/32, C08G 59/62, C08K 5/54

(54) **EPOXY RESIN COMPOSITION, PREPREG, LAMINATE BOARD AND MULTILAYER BOARD**
EPOXIDHARZZUSAMMENSETZUNG, PREPREG, LAMINATPLATTE UND MEHRSCHICHTIGE PLATTE
COMPOSITION DE RÉSINE ÉPOXY, PRÉ-IMPRÉGNÉ, PANNEAU STRATIFIÉ ET PANNEAU MULTICOUCHE

(30) Priority: 19.12.2008 JP 2008324651
(43) Date of publication of application: 28.09.2011
(73) Proprietor: Panasonic Intellectual Property Management Co., Ltd., Osaka-shi, Osaka 540-6207 (JP)
(72) Inventor: NISHINO, Mitsuyoshi, Kadoma-shi Osaka 571-8686 (JP); SATOU, Fuminori, Kadoma-shi Osaka 571-8686 (JP); FUJINO, Kentaro, Kadoma-shi Osaka 571-8686 (JP); NAKAMURA, Yoshihiko, Kadoma-shi Osaka 571-8686 (JP)
(74) Representative: Appelt, Christian W.
(86) International application number: PCT/JP2009/071021
(87) International publication number: WO 2010/071165

(56) References cited:
- WO-A1-2008/032383
- WO-A1-2008/032383
- JP-A- 5 163 373
- JP-A- 6 041 397
- JP-A- 9 316 178
- JP-A- 10 195 377
- JP-A- 2001 187 836
- JP-A- 2005 248 147
- JP-A- 2007 217 683

## Description

### Technical Field

The present invention relates to an epoxy resin composition, a prepreg, a laminate board and a multi-layer board.

### Background Art

A prepreg used as a material for a printed circuit board is prepared by diluting with a solvent a resin composition having as the main component a thermosetting resin such as epoxy resin and turning it into a varnish, impregnating a substrate such as a glass cloth with this varnish, and then drying this to bring the resin from an uncured state (A-stage) to a semi-cured state (B-stage).

Then, after the prepreg obtained in this way is cut into a prescribed size, a required number of sheets are superposed while at the same time a metal foil such as a copper foil is superposed on one side or both sides of these, and this is heat-pressed to form a laminate, allowing a metal-clad laminate board to be prepared, which is processed into a printed circuit board. At this stage, the resin changes from a semi-cured state (B-stage) to a fully cured state (C-stage), forming an insulation layer together with the substrate.

In recent years, the temperatures for mounting semiconductor chips onto printed circuit boards have been rising concomitantly to the use of lead-free solders. It is known that, when a curing agent having a phenolic hydroxyl group, such as cresol novolac resin, phenol novolac resin and bisphenol A novolac resin, is used as a curing agent in the epoxy resin composition used for the preparation of a prepreg for use in a printed circuit board, the thermal decomposition temperature of the hardened material from the epoxy resin composition and the glass transition temperature become higher compared to when an amine series curing agent is used, which is effective when using a lead-free solder (Patent Reference 1 refer).

However, there has been a problem that, when a curing agent having a phenolic hydroxyl group is used, the adhesive strength of the hardened material from the epoxy resin composition is significantly poorer compared to when an amine series curing agent is used.

In order to resolve this problem, mixing of an epoxy resin containing nitrogen and bromine in the molecule and mixing of an imidazole silane compound, into the epoxy resin composition, have been examined. However, among inner layer adhesive strength, inter-layer adhesive strength and metal foil adhesive strength, the inner layer adhesive strength could not be improved even if an imidazole silane compound was mixed. Note that, herein, "inner layer adhesive strength", when a multi-layer board is constituted by layering an insulation layer formed from an epoxy resin composition onto an inner layer material comprising an inner layer circuit board, refers to the adhesive strength at the interface between the inner layer material and the insulation layer. In addition, "inter-layer adhesive strength", when an insulation layer of a laminate board is formed from a prepreg prepared from an epoxy resin composition and a substrate such as a glass cloth, refers to the adhesive strength at the interface between the hardened material from the epoxy resin composition and the substrate in this insulation layer. In addition, "metal foil adhesive strength", when the insulation layer of a metal-clad laminate board is formed from a prepreg prepared from an epoxy resin composition and a substrate such as a glass cloth, refers to the adhesive strength at the interface between the insulation layer and the metal foil of this metal-clad laminate board.

In addition, there are also problems that, when an imidazole silane compound is mixed in large amounts into the epoxy resin composition in order to improve these adhesive strengths, the thermal decomposition temperature of the hardened material from this epoxy resin composition decreases, lowering heat resistance, the storage stability of the prepreg prepared from this epoxy resin composition decreases.

### Citation List

### Patent Literature

[PTL 1] Japanese Patent Application Laid-open No. H8-151507

WO 2008/032383 A1 describes an epoxy resin composition for a printed wiring board containing an epoxy resin component containing epoxy resin having a nitrogen atom and a bromine atom in each single molecule, a phenolic hardener component containing phenolic resin and a hardening accelerator component containing an imidazole silane compound.

JP 2007 217683 A describes an epoxy resin composition containing an epoxy resin, an inorganic filler and a silane compound effective for suppressing the agglomeration of the organic filler.

### Summary of Invention

### Tecnical Poblem

The present invention was devised in view of the above situation and an object thereof is to provide an epoxy resin composition having a high thermal decomposition temperature of the hardened material and a high heat resistance, as well as a high adhesive strength, in particular inner layer adhesive strength, and also provide a prepreg, a laminate board and a multi-layer board prepared from this epoxy resin composition.

### Solution to Problem

In order to solve the above problems, the present invention has the following characteristics.

The epoxy resin composition according to the present invention contains an epoxy resin containing nitrogen and bromine in the molecule, a curing agent having a phenolic hydroxyl group, and a silane compound having no cure acceleration action and having reactivity with the epoxy resin, the bromine content in a resin component of the epoxy resin composition being 10 mass% or greater.

A silane compound having no cure acceleration action refers to such a silane compound that, between when an epoxy resin composition contains and does not contain this silane compound, no difference is observed in the curing reactivity of the epoxy resin in this composition.

According to this invention, it is possible to increase the adhesive strength of the hardened material, in particular the inner layer adhesive strength, as well as providing a high heat resistance with a high thermal decomposition temperature of the hardened material. In addition, the required flame-resistance can be secured.

In the present invention, the silane compound is at least one species selected from epoxy silane compounds, isocyanate silane compounds and mercapto silane compounds.

In the present invention, the epoxy resin composition contains the silane compound at 0.2 to 2.0 mass% with respect to a total amount of the epoxy resin composition.

In this case, it is possible to increase the inner layer adhesive strength considerably, without impairing other physical properties.

In the present invention, the epoxy resin composition contains an imidazole silane compound in addition to the silane compound.

In this case, it is possible to increase all of the inner layer adhesive strength, the inter-layer adhesive strength and the metal foil adhesive strength, in a well balanced manner.

In the present invention, the epoxy resin composition contains the imidazole silane compound at 0.2 to 0.4 mass% with respect to a total amount the of epoxy resin composition.

In this case, it is possible to increase all of the inner layer adhesive strength, the inter-layer adhesive strength and the metal foil adhesive strength, in a well balanced manner, without impairing other physical properties such as heat resistance and the storage stability of the prepreg.

In the present invention, it is desirable that the epoxy resin contains an epoxy resin having an oxazolidone ring in the molecule as the epoxy resin containing nitrogen and bromine in the molecule.

In this case, the glass transition temperature of the hardened material can be increased in particular.

In the present invention, it is desirable that the epoxy resin composition contains an inorganic filler.

In this case, the coefficient of thermal expansion of the hardened material can be decreased.

The prepreg according to the present invention is one that is obtained by impregnating a substrate with the epoxy resin composition and performing drying.

According to this invention, it is possible to increase the adhesive strength, in particular the inner layer adhesive strength, as well as providing a high heat resistance with a high thermal decomposition temperature of the hardened material. In addition, the required flame-resistance can be secured.

The laminate board according to the present invention is one that is obtained by superposing and heat-pressing a required number of sheets of the prepreg to form a laminate.

According to this invention, it is possible to increase the adhesive strength, in particular the inner layer adhesive strength, as well as providing a high heat resistance with a high thermal decomposition temperature of the hardened resin material in the insulation layer. In addition, the required flame-resistance can be secured.

The multi-layer board according to the present invention is one that is obtained by superposing the prepreg on an inner layer circuit board and performing heat pressing thereon to form a laminate.

According to this invention, it is possible to increase the adhesive strength, in particular the inner layer adhesive strength, as well as providing a high heat resistance with a high thermal decomposition temperature of the hardened resin material in the insulation layer. In addition, the required flame-resistance can be secured.

### Description of Embodiments

Hereinafter, the present invention will be described in detail.

In the present invention, epoxy resins containing nitrogen and bromine in the molecule are used as the epoxy resin. This epoxy resin containing nitrogen and bromine in the molecule has adhesive strength that is high toward substrates such as glass cloth and metal foils such as copper foil. Among them, epoxy resins having an oxazolidone ring in the molecule are preferably used from the point of allowing the glass transition temperature to be increased.

In the present invention, from the point of improving the adhesive strength along with the thermal decomposition temperature of the hardened material to obtain high heat resistance, it is desirable that the epoxy resin composition contains another epoxy resin, along with the epoxy resin containing nitrogen and bromine in the molecule. As such epoxy resin, epoxy resins containing no nitrogen and no bromine in the molecule and epoxy resins containing bromine without containing nitrogen in the molecule can be cited. As concrete examples thereof, although there is no particular limitation if the epoxy resin has two or more epoxy groups in one molecule, phenol novolac type epoxy resins, cresol novolac type epoxy resins, bisphenol A novolac type epoxy resins, bisphenol A type epoxy resins, bisphenol F type epoxy resins, biphenyl type epoxy resins, alicyclic epoxy resins, diglycidyl ether compounds of multifunctional phenol, diglycidyl ether compounds of multifunctional alcohol, and epoxy resins containing bromine, may be cited. These may be used alone, or two species or more may be used in combination.

When an epoxy resin containing no nitrogen and no bromine in the molecule or an epoxy resin containing bromine without containing nitrogen in the molecule mentioned above is used in combination with an epoxy resin containing nitrogen and bromine in the molecule, the content, with respect to the total amount of the epoxy resin, of the epoxy resin containing nitrogen and bromine in the molecule is preferably 10 to 70 mass%. If this content is too low, the adhesiveness sometimes decreases and if this content is too large, heat resistance sometimes decreases.

In the present invention, the epoxy resin composition contains a curing agent having a phenolic hydroxyl group. Using a curing agent having a phenolic hydroxyl group allows heat resistance to be increased. As curing agents having a phenolic hydroxyl group, multivalent phenol compounds, and, multivalent naphthol compounds, may be cited. As concrete examples of multivalent phenol compound, bisphenol A novolac resin, phenol novolac resin, cresol novolac resin, phenol aralkyl resin, biphenyl aralkyl resin, and the like, may be cited. As concrete examples of multivalent naphthol compound, naphthol aralkyl resin, and the like, may be cited. These may be used alone, or two species or more may be used in combination. Among them, if bisphenol A novolac resin is used, the toughness of the hardened material can be increased, further increasing the adhesive strength. In addition, when the bisphenol A novolac resin contains a given amount of bifunctional bisphenol A or more, the formability of the epoxy resin composition also improves.

The content in curing agent having a phenolic hydroxyl group is preferably an amount such that the equivalent ratio of phenolic hydroxyl group over epoxy group (OH group equivalent/epoxy group equivalent) is 0.5 to 1.5 and more preferably an amount such that the equivalent ratio is 0.8 to 1.2. If the equivalent ratio is outside this range, insufficient curing or decrease in the physical properties of the hardened material sometimes occur.

In order to secure the flame-resistance required as a printed circuit board, the epoxy resin composition of the present invention has a bromine content of 10 mass% or greater with respect to the total amount of the epoxy resin and the curing agent, which are the resin component of the epoxy resin composition.

In the present invention, the epoxy resin composition contains a silane compound having no cure acceleration action and having reactivity with the epoxy resin in this epoxy resin composition. As such silane compounds, epoxy silane compounds (glycidoxy silane compounds), isocyanate silane compounds and mercapto silane compounds may be cited. These silane compounds may be used alone, or two species or more may be used in combination. Including such silane compounds in the epoxy resin composition allows the adhesive strength, in particular the inner layer adhesive strength, of the hardened material to be increased considerably.

Note that, when only a silane compound having cure acceleration effect, such as imidazole silane, amino-silane and the like, is used as the silane compound, improvement of the inner layer adhesive strength is not sufficient since these silane compounds contribute to the reaction in the B-stage state. In addition, when only a silane compound not reacting with the epoxy resin, such as vinyl silane, is used as the silane compound, improvement of the inner layer adhesive strength is no longer obtained.

As concrete examples of epoxy silane compound (glycidoxy silane compound), γ-glycidoxy propyltrimethoxy silane, γ-glycidoxy propyltriethoxy silane, γ-glycidoxy propylmethyldiethoxy silane, and γ-(3,4-epoxy cyclohexyl)ethyltrimethoxy silane, may be cited.

As concrete examples of isocyanate silane compound, 3-isocyanate propyltriethoxy silane, and, 3-isocyanate propyltrimethoxy silane, may be cited.

As concrete examples of mercapto silane compound, 3-mercapto-propyltrimethoxy silane, 3-mercapto-propyltriethoxy silane, and 3-mercapto-propyl methyl dimethoxy silane, may be cited.

The content in silane compound having no cure acceleration action and having reactivity with the epoxy resin in this epoxy resin composition is 0.2 to 2.0 mass% with respect to the total amount of the epoxy resin composition. Having a content in silane compound within this range, allows the inner layer adhesive strength to be increased considerably without impairing other physical properties.

In the present invention, an imidazole silane compound can be included in the epoxy resin composition, in addition to the silane compound having no cure acceleration action and having reactivity with the epoxy resin in this epoxy resin composition. Including an imidazole silane compound allows all of the inner layer adhesive strength, the inter-layer adhesive strength and the metal foil adhesive strength to be increased in a well balanced manner. As concrete examples of imidazole silane compound, silane compounds having an imidazole group and an alkoxysilyl group in the molecule, for instance, "IM1000" manufactured by Nikko Materials Co., Ltd., may be cited.

The content in imidazole silane compound is preferably 0.2 to 0.4 mass% with respect to the total amount of the epoxy resin composition. Having a content in imidazole silane compound within this range allows all of the inner layer adhesive strength, the inter-layer adhesive strength and the metal foil adhesive strength to be increased in a well balanced manner without impairing other physical properties such as heat resistance and the storage stability of the prepreg.

A cure accelerator can be included in the epoxy resin composition of the present invention. As concrete examples of cure accelerator, imidazoles such as 2-ethyl 4-methyl imidazole, 2-methyl imidazole and 2-phenyl imidazole, may be cited. These may be used alone, or two species or more may be used in combination.

An inorganic filler can be included in the epoxy resin composition of the present invention. Including an inorganic filler in the epoxy resin composition allows the coefficient of thermal expansion of the hardened material to be decreased. As concrete examples of inorganic filler, aluminum hydroxide, silica, and magnesium hydroxide, may be cited. These may be used alone, or two species or more may be used in combination. Preferably, inorganic fillers with an average particle diameter of 0.1 to 5 µm are used.

The content in inorganic filler is preferably 5 to 120 parts in mass with respect to a total amount of 100 parts in mass of the epoxy resin and the curing agent, which are the resin component of the epoxy resin composition. Having a content in inorganic filler within this range allows the coefficient of thermal expansion of the hardened material to be decreased without impairing other physical properties.

Note that, in the present invention, the silane compound having no cure acceleration action and having reactivity with the epoxy resin is mixed into the epoxy resin composition separately and independently from the inorganic filler. The effects of the present invention cannot be obtained by reacting the silane compound beforehand with the inorganic filler and surface-treating similarly to an ordinary silane coupling agent and using this.

The epoxy resin composition of the present invention can be prepared as a varnish by mixing the above-mentioned epoxy resin, curing agent having a phenolic hydroxyl group, silane compound having no cure acceleration action and having reactivity with the epoxy resin in this epoxy resin composition, and, as necessary, other components. When preparing as a varnish, it may be diluted with a solvent. As concrete examples of solvent, amides such as N,N-dimethyl formamide (DMF), ethers such as ethylene glycol monomethyl ether, ketones such as acetone and methyl ethyl ketone, alcohols such as methanol and ethanol, aromatic hydrocarbons such as benzene and toluene, may be cited.

When preparing the prepreg of the present invention, a substrate is impregnated with the epoxy resin composition prepared as varnish. Then, for instance, heat drying at 130 to 170°C for 3 to 15 minutes in a dryer allows a prepreg in the semi-cured state (B-stage) to be prepared.

As the substrate, glass fibers such as glass cloth, glass paper and glass mat can be used, and in addition, craft paper, natural fiber cloth, and organic synthetic fibre cloth can be used.

The laminate board of the present invention can be prepared by superposing a required number of sheets of the prepreg obtained in the manner described above and performing heat pressing thereon, for instance, under the conditions of 140 to 200°C, 0.5 to 5.0 MPa and 40 to 240 minutes to form a laminate.

In so doing, a metal-clad laminate board can be prepared by superposing a metal foil on the prepreg at the outermost layer on one side or on both sides and heat-pressing these to form a laminate. As the metal foil, copper foil, silver foil, aluminum foil, and stainless foil can be used.

The multi-layer board of the present invention can be prepared as follows: an inner layer circuit board is prepared beforehand by forming an inner layer circuit in the metal foil on one side or on both sides of a metal-clad laminate board by an additive method, or a subtractive method, along with performing blacking processing on the surface of this circuit using an acid solution.

Then, the multi-layer board can be prepared by superposing the required number of sheets of the above prepreg on one side or both sides of this inner layer circuit board, as necessary, further superposing a metal foil on the external surface thereof, and heat-pressing this to form a laminate.

Then, a printed circuit board or a multilayered printed circuit board can be prepared by forming via an additive method, or a subtractive method a circuit on one side or both sides of the laminate board or the multi-layer board prepared in the manner described above, and as necessary undergoing processing such as drilling by laser processing, or drill processing, and plating this hole to form a via hole or a through-hole.

### Examples

Hereinafter, the present invention will be described in further detail with the examples.

As ingredients of the epoxy resin compositions in the examples and comparative example, the following were used:

### ] (Epoxy resins)

"DER593" manufactured by The Dow Chemical Company, an epoxy resin with epoxy equivalent of 330 to 390 g/eq, a bromine content ratio of 17 to 18 mass%, intramolecular average epoxy group content of 2, and containing nitrogen and bromine in the molecule.

"N690" manufactured by DIC Corporation, an epoxy resin with an epoxy equivalent of 190 to 240g/eq, a bromine content ratio of 0 mass%, intramolecular average epoxy group content of 5 to 3, and containing neither nitrogen nor bromine in the molecule.

"EPICLON 1121" manufactured by DIC Corporation, a bisphenol A type epoxy resin with an epoxy equivalent of 450 to 530g/eq, a bromine content ratio of 19 to 22 mass%, intramolecular average epoxy group content of 2, and containing bromine without containing nitrogen in the molecule.

"YDB-400" manufactured by Tohto Kasei Co., Ltd., an epoxy resin with an epoxy equivalent of 400g/eq, a bromine content ratio of 48 mass%, and containing bromine without containing nitrogen in the molecule.

### (Curing agent having a phenolic hydroxyl group)

"VH4170" manufactured by DIC Corporation, a bisphenol A novolac resin with a hydroxyl group equivalent of 118g/eq, a resin softening point of 105°C, and a content in bifunctional bisphenol A of approximately 25%.

### (Inorganic fillers)

Silica "SO-25R" manufactured by Admatechs Co., Ltd., with an average particle diameter of 0.4 to 0.6 µm, and spherical.

Silica surface treated with an epoxy silane compound "SC2500-SEJ" manufactured by Admatechs Co., Ltd., with an average particle diameter of 0.4 to 0.6 µm, and spherical.

Aluminum hydroxide "C-303" manufactured by Sumitomo Chemical Co., Ltd., with an average particle diameter of approximately 4 µm.

### (Epoxy silane compound)

γ-glycidoxy propyltrimethoxy silane "A-187" manufactured by GE Toshiba Silicones.

γ-glycidoxy propyl methyl diethoxy silane "KBE-402" manufactured by Shin-Etsu Silicone Co., Ltd.

### (Vinyl silane compound)

Vinyltriethoxy silane "KBE-1003" manufactured by Shin-Etsu Silicone.

### (Isocyanate silane compound)

3-isocyanate propyltriethoxy silane "KBE-9007" manufactured by Shin-Etsu Silicone.

### (Mercapto silane compound)

3-mercapto-propyltrimethoxy silane "KBM-803" manufactured by Shin-Etsu Silicone.

### (Amino silane compound)

3-amino propyltriethoxy silane "KBE-903" manufactured by Shin-Etsu Silicone.

### (Imidazole silane compound)

"IM1000" manufactured by Nikko Materials Co., Ltd.

### (Cure accelerator)

2-ethyl-4 methyl imidazole "Curezol 2E4MZ" manufactured by Shikoku Chemicals Corporation.

### [Preparation of resin varnish]

The above ingredients were mixed with the mixing amounts of Table 1 (parts in mass), diluted with solvent, and then stirred and homogenized with a disperser. The amount of solvent was adjusted so as to have a proportion of 60 to 75 mass% for the ingredients other than the solvent (solid content including epoxy resin and curing agent). When an inorganic filler was to be mixed, a given mixing amount of inorganic filler was further mixed, and then stirred further for two hours with a disperser. In this way, the epoxy resin compositions (varnish) of the examples and comparative examples were obtained.

### [Prepreg preparation conditions]

Prepreg was prepared by using a glass cloth ("7628 type cloth" manufactured by Nitto Boseki Co., Ltd.) as a substrate, impregnating this glass cloth with the varnish of epoxy resin composition at room temperature and thereafter heating with a non-contact type heating unit at approximately 130 to 170°C to dry-remove the solvent in the varnish and semi-cure the epoxy resin composition. The amount of resin in the prepreg was adjusted so as to have 100 parts in mass of resin with respect to 100 parts in mass of glass cloth (50 mass% of resin). In addition, drying condition was adjusted so as to have a gel time of 120 ± 5 s for the prepreg. This prepreg gel time is the value of the time until gelation measured after a resin portion collected from the prepreg is placed on a heat plate at 170°C.

### [Copper-clad laminate board forming conditions]

A copper-clad laminate board was obtained by sandwiching four sheets (340 mm × 510 mm) of the prepreg prepared in the description above between the roughened faces of two sheets of copper foil (35 µm-thick, JTC foil manufactured by Nikko Gould Foil Co., Ltd.) and laminate-forming at 170°C and 2.94 MPa for 90 minutes.

### <Gel time>

The time until gelation was measured after the varnish of epoxy resin composition prepared in the description above was placed on a heat plate at 170°C.

### <Conservation stability>

The gel time of the prepreg prepared in the description above was measured. In addition, the prepreg prepared in the description above was stored for 90 days under 20°C/50%RH condition, and then the gel time of the prepreg was measured. This prepreg gel time is the value of the time until gelation measured after a resin portion collected from the prepreg is placed on a heat plate at 170°C. As a result, the evaluation was "Good" when the change in gel time between before and after the treatment was within 15 s and "Bad" when the change exceeds 15 s.

### <Inner layer adhesive strength>

The non-roughened faces of the copper foils of the copper-clad laminate board prepared in the above description were treated (inner layer treatment) with an oxide treatment solution commercialized by Nippon MacDermid Co., Ltd. (Product No.: BO200). With this copper-clad laminate board serving as the inner layer material, the two sides of the inner layer-treated faces thereof, a prepreg and a copper foil with the same constitution as those used in the preparation of this copper-clad laminate board were sequentially superposed to prepare a laminate. The copper foil was superposed with the roughened surface thereof against the prepreg. This laminate was formed by heat pressing under the conditions of 170°C and 2.94 MPa for 90 minutes to obtain a multi-layer board (four-layer board).

This multi-layer board was split into two at the location where the central insulation layer (insulation layer in the inner layer material) was formed, and the disjoined surfaces were further polished to expose copper foil. The 90-degree peel strength when this exposed copper foil is peeled off was measured according to JIS C6481.

### <Inter-layer adhesive strength>

The 90-degree peel strength when one sheet worth of glass cloth of the copper-clad laminate board prepared in the above description is peeled off along with a copper foil was measured according to JIS C6481.

### <Copper foil adhesive strength>

The 90-degree peel strength when the copper foil of the copper-clad laminate board prepared in the above description is peeled off was measured according to JIS C6481.

### <Glass transition temperature>

For the copper-clad laminate board prepared in the above description, the glass transition temperature (Tg) of the resin hardened material in the insulation layer was measured by the TMA method (Thermo-mechanical analysis) according to JIS C6481.

### <Thermal decomposition temperature>

The copper foil was peeled off from the copper-clad laminate board prepared in the above description to obtain a laminate board. The weight change at heating time of this laminate board was measured with a heat weight change measurement apparatus (TG-DTA), under the condition of 5°C/minute heat increase speed. The temperature at which the amount of weight decrease of this laminate board reached 5% of the weight at measurement starting time served as the thermal decomposition temperature.

### <Oven heat resistance>

Approximately 0.4 mm-thick copper-clad laminate board prepared in the above description was heated in an oven at a variety of heating temperatures for 60 minutes heat, then, copper-clad laminate board after the treatment was visually observed to check for the presence/absence of bulges and peeling. The heating temperature limit (maximum) at which no bulge and no peeling were identified served as the evaluation index for heat resistance.

### <Coefficient of Thermal Expansion (CTE)>

For the copper-clad laminate board prepared in the above description, Coefficient of Thermal Expansion in the plate thickness direction was measured by the TMA method (Thermo-mechanical analysis) at a temperature below the glass transition temperature of the resin hardened material in the insulation layer, according to JIS C6481.

The results of each measurement and evaluation above carried out for the examples and comparative examples are shown in Table 1. Note that, bromine content in the resin component of the epoxy resin composition was 10 mass% or greater in all examples and comparative examples, and flame-resistance of the copper-clad laminate board was V-0 by the UL method.

Examples 1 to 4 and 6 to 9 are also not the present invention.

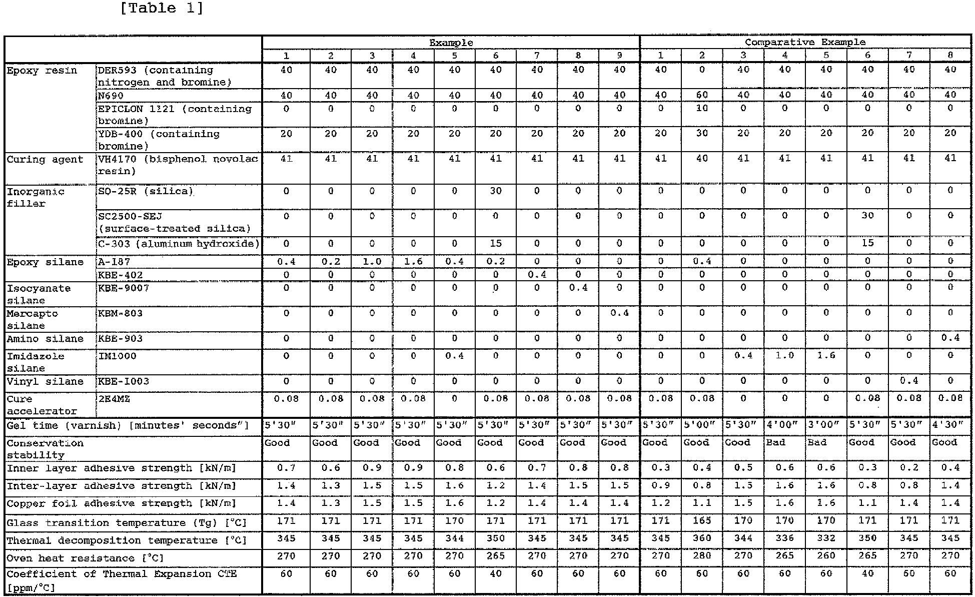

From Table 1, with Examples 1-4 and 6-9 (examples not the invention) and Example 5 in which an epoxy resin containing nitrogen and bromine in the molecule, a curing agent having a phenolic hydroxyl group, and a silane compound having no cure acceleration action and having reactivity with the epoxy resin were mixed, heat resistance (thermal decomposition temperature and oven heat resistance) was high, furthermore, the adhesive strength, in particular the inner layer adhesive strength was high. Then, the gel time, conservation stability, glass transition temperature, coefficient of thermal expansion were also satisfactory as printed circuit board application. In particular, as can be seen in Examples 1, 3 to 4 and 7 to 9, and Example 5 of the invention, satisfactory results were obtained when 0.2 to 2.0 mass% of silane compound having no cure acceleration action and having reactivity with the epoxy resin was included with respect to the total amount of the epoxy resin composition.

Among them, with Example 5 in which along with epoxy silane compound imidazole silane compound was used in combination, the inner layer adhesive strength, the inter-layer adhesive strength and the copper foil adhesive strength were overall excellent in a well balanced manner. In particular, satisfactory results were obtained when 0.2 to 0.4 mass% of imidazole silane compound was included with respect to the total amount of the epoxy resin composition.

With Example 6 (not the invention), in which an inorganic filler was mixed, the coefficient of thermal expansion decreased while the heat resistance and the adhesive strength increased.

Meanwhile, with Comparative Examples 1 and 3 to 6 in which a silane compound having no cure acceleration action and having reactivity with the epoxy resin was not mixed, the adhesive strength, in particular the inner layer adhesive strength decreased. With Comparative Examples 3 to 5, although an imidazole silane compound was mixed, no remarkable improvement was observed in the inner layer adhesive strength as seen in Comparative Example 3, in addition, if the mixing amount of imidazole silane compound is increased as in Comparative Examples 4 and 5, a decrease in heat resistance, gel time and conservation stability was observed. In addition, absolutely no effect was seen with Comparative Example 6 in which used silica surface-treated beforehand with an epoxy silane compound.

With Comparative Example 2 in which an epoxy resin containing nitrogen and bromine in the molecule was not mixed, the adhesive strength and glass transition temperature decreased.

## Claims

1. An epoxy resin composition containing an epoxy resin containing nitrogen and bromine in the molecule, a curing agent having a phenolic hydroxyl group, a silane compound being at least one species selected from an epoxy silane compound, an isocyanate silane compound and a mercapto silane compound, and an imidazole silane compound in addition to the silane compound wherein the bromine content in a resin component of the epoxy resin composition being 10 mass% or greater,
a content of the silane compound being at least one species selected from the epoxy silane compound, the isocyanate silane compound and the mercapto silane compound with respect to a total amount of the epoxy resin composition is 0.2 to 2.0 mass%, and
a content of the imidazole silane compound with respect to the total amount of the epoxy resin composition is 0.2 to 0.4 mass%.

2. The epoxy resin composition according to Claim 1, wherein the epoxy resin contains an epoxy resin having an oxazolidone ring in the molecule.

3. The epoxy resin composition according to Claim 1 or 2, containing an inorganic filler.

4. A prepreg obtained by impregnating a substrate with the epoxy resin composition according to any one of Claims 1 to 3 and heat drying.

5. A laminate board obtained by superposing a required number of sheets of the prepreg according to Claim 4 and heat pressing thereon form a laminate.

6. A multi-layer board obtained by superposing a required number of the prepreg according to Claim 4 one or both sides of an inner layer circuit board and heat pressing thereon to form a laminate.

## Patentansprüche

1. Epoxidharzzusammensetzung, die ein Epoxidharz, das Stickstoff und Brom im Molekül enthält, ein Härtungsmittel, das eine phenolische Hydroxylgruppe aufweist, eine Silan-Verbindung, die mindestens eine Spezies ausgewählt aus einer Epoxysilan-Verbindung, einer Isocyanatsilan-Verbindung und einer Mercaptosilan-Verbindung ist, und eine Imidazolsilan-Verbindung zusätzlich zu der Silan-Verbindung enthält, wobei der Bromgehalt in einer Harzkomponente der Epoxidharzzusammensetzung 10 Massenprozent oder mehr beträgt,
ein Gehalt der Silan-Verbindung, die mindestens eine Spezies ausgewählt aus der Epoxysilan-Verbindung, der Isocyanatsilan-Verbindung und der Mercaptosilan-Verbindung ist, in Bezug auf eine Gesamtmenge der Epoxidharzzusammensetzung 0,2 bis 2,0 Massenprozent beträgt, und
ein Gehalt der Imidazolsilan-Verbindung in Bezug auf die Gesamtmenge der Epoxidharzzusammensetzung 0,2 bis 0,4 Massenprozent beträgt.

2. Epoxidharzzusammensetzung nach Anspruch 1, wobei das Epoxidharz ein Epoxidharz enthält, das einen Oxazolidon-Ring im Molekül aufweist.

3. Epoxidharzzusammensetzung nach Anspruch 1 oder 2, die einen anorganischen Füllstoff enthält.

4. Prepreg, das durch das Imprägnieren eines Substrats mit der Epoxidharzzusammensetzung nach einem der Ansprüche 1 bis 3 und Wärmetrocknung erhalten wird.

5. Laminatplatte, die durch das Übereinanderlegen einer erforderlichen Zahl von Bahnen des Prepregs nach Anspruch 4 und das Anwenden von Heißpressen darauf, um ein Laminat zu bilden, erhalten wird.

6. Mehrschichtige Platte, die durch das Übereinanderlegen einer erforderlichen Zahl des Prepregs nach Anspruch 4 auf einer oder beiden Seiten einer Innenschicht-Leiterplatte and das Anwenden von Heißpressen darauf, um ein Laminat zu bilden, erhalten wird.

## Revendications

1. Composition de résine époxy contenant une résine époxy contenant de l'azote et du brome dans sa molécule, un agent durcisseur ayant un groupe hydroxyle phénolique, un composé silane qui est au moins une espèce choisie parmi un composé époxysilane, un composé isocyanatosilane et un composé mercaptosilane, et un composé imidazolesilane en plus du composé silane, dans laquelle
la teneur en brome du composant résine de la composition de résine époxy est de 10 % en masse ou plus,
la teneur en composé silane qui est au moins une espèce choisie parmi un composé époxysilane, un composé isocyanatosilane et un composé mercaptosilane, par rapport à la quantité totale de la composition de résine époxy, est de 0,2 à 2,0 % en masse, et
la teneur en le composé imidazolesilane par rapport à la quantité totale de la composition de résine époxy est de 0,2 à 0,4 % en masse.

2. Composition de résine époxy selon la revendication 1, dans laquelle la résine époxy contient une résine époxy ayant un cycle oxazolidone dans sa molécule.

3. Composition de résine époxy selon la revendication 1 ou 2, contenant une charge inorganique.

4. Préimprégné obtenu par imprégnation d'un substrat avec la composition de résine époxy selon l'une quelconque des revendications 1 à 3 et séchage à la chaleur.

5. Panneau stratifié obtenu par superposition d'un nombre requis de feuilles du préimprégné selon la revendication 4 et pressage à la chaleur sur celles-ci pour former un stratifié.

6. Panneau multicouche obtenu par superposition d'un nombre requis des préimprégnés selon la revendication 4 sur un côté ou les deux côtés d'une carte de circuit à couche intérieure et pressage à la chaleur sur ceux-ci pour former un stratifié.
